# EUROPEAN PATENT APPLICATION

(11) **EP 4 553 188 A1**
(43) Date of publication of application: **14.05.2025**
(21) Application number: 24210954.4
(22) Date of filing: 05.11.2024
(51) Int. Cl.: C23C 16/46, C30B 25/10, C30B 23/06

(54) **FAST COOLING REACTOR FOR EPITAXIAL DEPOSITION OF SEMICONDUCTOR FILMS**

(30) Priority: 08.11.2023 IT 202300023547
(71) Applicant: LPE S.p.A., 20021 Baranzate (MI) (IT)
(72) Inventor: MESCHIA, Maurilio Giuseppe, I-20021 BARANZATE, MILANO (IT); BIBOLOTTI, Alberto, I-20021 BARANZATE, MILANO (IT)
(74) Representative: Di Biase, Fabio

(57) **Abstract**

The present invention relates to a reactor (1) suitable for the epitaxial deposition of a semiconductor film on a substrate and adapted to reduce cool down times of the reactor after operation. The reactor features a reaction chamber (10) and a thermal insulation system. The latter comprises a plurality of thermally insulating components (110, 120, 130, 140, 150) and at least one actuator (200) adapted to displace at least one of the thermally insulating components to minimize or maximize the thermal insulation of the reaction chamber as needed. The present invention further relates to a use of the reactor hereinbefore described and to a method for operating the same.

## Description

### FIELD OF INVENTION

The present invention relates to the field of epitaxial deposition of semiconductor films on substrates; in particular to a reactor adapted to reduce cool down times after deposition, and to a method for operating the same.

Additionally, though not exclusively, the present invention relates to the field of the deposition of silicon, silicon carbide, and gallium arsenide films on a semiconductor substrate in a hot-wall, crossflow homoepitaxial or heteroepitaxial reactor.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface features, making them suitable for the manufacturing of highly complex microprocessors and memory devices.

Typically, the reaction chamber is heated to a desired temperature before film deposition, and the temperature is maintained substantially constant throughout the deposition process. To this effect, insulating systems are used to reduce the energy required to achieve and maintain the nominal temperature of the deposition process. For instance, one or more casings of thermally insulating materials may enclose the reaction chamber, thereby limiting heat dispersion in the neighboring environment.

The ability to maintain a constant and controlled temperature also impacts on the quality of the film's growth. However, the more efficient the insulation, the longer is the downtime required to cool the reactor after deposition, in order to open the chamber to extract and handle the treated substrate.

This issue is particularly felt in hot-wall reactors, which may be advantageously used in the epitaxial deposition of silicon (Si), silicon carbide (SiC) and gallium nitride (GaN) on semiconductor substrates (of the same or different materials). In the above non limiting examples, the chambers usually operate at very high temperatures, between 800-1800 °C, depending on the chemistry. In these hot-wall reactors, the walls of the reaction chamber are actively heated and kept hot during operation. One or more walls may be made of materials with high susceptivity, such as graphite, and heated via induction means. In any event, the high temperatures reached by the chamber and its surrounding walls affect the cooling time and the overall efficiency of the reactor operations.

Cooling of the reactor, and specifically of the reaction chamber, typically takes place via any of the following passive and active means, taken alone or in combination: (i) irradiation, (ii) conduction through the insulating and susceptive elements of the reactor, (iii) flow of hydrogen into the chamber.

Despite the above, the reactors still present long cooling downtimes. For instance, it may take up to 20 minutes to cool a SiC hot-wall reactor from 1650 °C down to 900 °C (which is approximately the maximum temperature at which the reaction chamber may be opened to extract the substrates after deposition).

WO2023/037278 discloses a reactor for epitaxial deposition of semiconductor material on substrates comprising a reaction chamber of box-like shape and a thermal insulating plate that provides a variable thermal insulation by sliding over the reaction chamber. This design, however, may additionally contribute to the presence of debris in the chamber since it involves sliding surfaces and actuating pieces in the close proximity of the reaction chamber, and just above the upper wall of the same. This may affect the quality of the epitaxial deposition and/or require further cleaning. Additionally, the prior art design is not applicable "as is" to cylindrical reactors, such as the one disclosed in EP1570107, which advantageously allows to heat the reaction chamber uniformly and efficiently.

It is therefore desirable to provide a new method for reducing the cooling downtime of a cylindrical reactor, in particular, but not exclusively, of a hot-wall reactor for the deposition of Si, SiC, and GaN films on semiconductor substrates of same or different materials. It is furthermore desirable that the new method maintains proper insulation of the reaction chamber during the heating and epitaxial deposition process, while limiting possible contamination of the deposition area with debris. Furthermore, it is desirable to provide a new reactor suitable to implement the aforementioned method.

### SUMMARY OF THE DISCLOSURE

It as an object of the present invention to overcome the disadvantages of the prior art. In particular, it is an object of the present invention to provide a method for reducing the cooling downtime of a reactor, in particular, but not exclusively, of a hot-wall reactor for the deposition of Si, SiC, and GaN films on semiconductor substrates of same or different materials. It is a further object of the present invention to provide a method which maintains proper insulation of the reaction chamber during heating and during epitaxial deposition, while limiting possible contamination of the deposition area with debris. Under a different aspect, it is an object of the present invention to provide a new reactor suitable to implement the method hereinbefore described as well as a use of said reactor for the deposition of Si, SiC, and GaN films on semiconductor substrates.

The main objectives hereinbefore described are achieved through the invention recited in the appended claims, which constitute an integral part of the present description. The use of reference signs in the claims does not limit their scope. The sole purpose of reference signs is to make the claims easier to understand.

This summary is provided to introduce a selection of concepts in a simplified form. These concepts are further described in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

Fig. 1 provides simplified sketches of the reactor according to a first embodiment of the present invention comprising a linear actuator.
Fig. 2 provides simplified sketches of the reactor according to a second embodiment of the present invention comprising a linear actuator.
Fig. 3 provides simplified sketches of the reactor according to a third embodiment of the present invention comprising a rotary actuator.

It will be appreciated that elements in the figures are illustrated for simplicity and clarity and have not necessarily been drawn to scale. For example, some of the elements in the figures may have been omitted or the dimensions exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Epitaxial reactors of cylindrical shape, such as those described in EP 1570107 and US2022411961, have proven commercially successful thanks to the uniformity and efficiency of the heating of the reaction chamber, the simplicity of construction, and the quality of the deposited films.

These cylindrical reactors typically extend rather uniformly along a longitudinal horizontal direction and exhibit a substantially circular cross section.

They comprise a reaction chamber, formed by one or more structural elements. Some of these structural elements may exhibit high susceptivity, for instance they can be made of graphite and optionally exhibit a half-moon shape. They may be heated via induction means, such as one or more induction coils wrapped around the reactor. Other structural elements of the reaction chamber may be made of a different material to impart preferential current flows in the susceptive elements and expedite their induction heating.

The above structural elements combine to form a substantially circular cross section and are surrounded by an upper and a lower casing made of a thermally insulating material. To this effect, porous carbonaceous materials can be used, for instance carbon composites made from short cut carbon fibers, optionally interconnected in a matrix or pressed together.

The above cylindrical reactors may be surrounded by an enclosure, which may be made of quartz or other material that is relatively transparent to induction heating and that is resistant to high temperature. This enclosure may be cooled with a fluid such as water to maintain its structural properties even when exposed to high temperatures.

Cylindrical reactors like the ones described in the above non limiting example, which is provided solely for illustrative purposes, heat up very efficiently but typically require more up to 20 minutes to cool down, affecting the overall efficiency and throughput rate of the reactor. To reduce the cooling downtime and improve the throughput rate, the following invention has been conceived. It is noted that while the present invention can be advantageously implemented in the cylindrical reactors hereinbefore described, its general teaching can be successfully applied in a variety of different scenarios without departing from the scope of the invention.

Under one aspect, the present invention relates to a reactor suitable for the epitaxial deposition of a semiconductor film on a substrate, comprising:
(i) a reaction chamber formed by at least one partition element and having a base adapted to receive a substrate holder; and
(ii) a thermal insulation system adapted to provide thermal insulation for the reaction chamber by substantially enclosing the at least one partition element.

The above reactor is characterized by a substantially cylindrical shape: it extends along a longitudinal axis and features a mainly circular cross section. It is understood, here and in the following, that the expressions "mainly circular" or "substantially circular" also encompass other rounded, elliptical, or oval shapes. Indeed, these shapes may be used in the same way, with the same purpose, to achieve the same or similar result, and are therefore equivalent in the context of the present invention.

The thermal insulation system, which features a substantially circular cross section adapted to the cylindrical shape of the reactor, comprises a plurality of thermally insulating components and at least one actuator.

The thermally insulating components have a circular or arc-shaped cross section and should be made of a rigid material suitable to withstand the high temperatures reached by the reactor. For instance, though not exclusively, they can be made of rigid carbonaceous materials (such as materials comprising short cut carbon fibers, optionally interconnected in a matrix or pressed together).

All surfaces of the thermally insulating components may be advantageously coated to improve their compactness and reduce the formation of debris, as may result from the detachment of fibers or other particles from the bulk insulating material. The coating used may be a graphite-based coating.

With the term "actuator" it is meant a part of a device or machine that allows it to produce physical movements. The "actuator" in the present context can be used to convert electrical, mechanical, gaseous, or hydraulic inputs into a linear or a rotary movement, or to a sequential combination of both.

The actuator according to the invention is coupled to at least one of the thermally insulating components and is adapted to displace it from an insulating position to a cooling position (and vice versa). The insulating position and the cooling position are respectively adapted to relatively maximize and relatively minimize the thermal insulation of the reaction chamber by variably tuning the overall insulating coverage of same.

Because of space constraints within the reactor, the thermally insulating components may not always be displaced to reach the absolute maximum/minimum thermal insulation of the reaction chamber. Hence the insulating position and the cooling position typically maximize and minimize the thermal insulation of the reaction chamber "relatively" to one another.

It is noted that the mobility of the thermally insulating components with respect to each other allows to tailor the insulating properties of the insulating system. This effect is achieved via the displacement of said components, which can be designed to create apertures in the insulating system or to locally alter its thickness.

Depending on the position of the mobile thermally insulating component(s), and the entity and type of their displacement (linear or rotary), a certain number of debris may be generated and reach the reaction chamber. However, the cylindrical geometry of the reactor should reduce or cancel this negative side effect. Indeed, any fragments generated above the reaction chamber due to the displacement of parts are likely to preferentially fall toward the sides and then below the reaction chamber, thereby reducing the probability to contaminate its interiors.

To further minimize the debris that can be generated, preferably the thermally insulating component that is coupled to the actuator (and is therefore subject to displacement) should not bear any additional weight besides its own, nor be subject to any external forces. This will help minimize the friction generated by its displacement.

Under a first embodiment, the reactor according to the invention comprises at least one cover jacket positioned between the one or more partition elements and the thermal insulation system. By providing an additional layer of mechanical protection, the cover jacket can prevent debris generated by the actuation of the thermally insulating components from reaching the reaction chamber.

The cover jacket is a rigid element and can be advantageously made of graphite. Alternatively, a thermally insulating material, such as a porous carbonaceous structure, can be used. Carbon composites made from porous carbonaceous materials, such as short cut carbon fibers, optionally interconnected in a matrix or pressed together, have be observed to work particularly well in the execution of the invention. In this case, all surfaces of the cover jacket may be coated to improve their compactness and reduce the formation of debris, as may result from the detachment of fibers or other particles from the bulk insulating material. The coating may be graphite-based.

Under a second embodiment, which may be implemented in alternative or in addition to the first, the actuator is made of, or coated with, a heat resistant material suitable to the temperatures reached within the reactor, but outside the insulated chamber. Typically, such temperatures are in the 400-800°C range. The heat resistant material may be advantageously chosen from: borosilicate glass, sapphire glass, quartz, ceramic, graphite, or their combinations. These materials allow the actuator to be placed within the reactor without detriment to its operation and lifetime.

In general, the actuator may be a linear actuator, and cause a displacement of the thermally insulating component along the longitudinal axis, or a rotary actuator, thus allowing a rotation of the thermally insulating component around the longitudinal axis.

It is advantageous for the actuator to exhibit low friction and to have no seals or gaskets, to avoid any stick-slip phenomena that may alter the smoothness of the movement imparted on the thermally insulating component.

Under a further embodiment, the actuator of the reactor according to the invention comprises a cylinder and a piston. The latter is adapted to move within the cylinder from a retracted position to an extended position and vice versa. The piston is coupled, connected or connectable to at least one of the thermally insulating components to cause its displacement from the cooling position to the insulating position and vice versa.

Advantageously, but not exclusively, in the embodiment above the piston may move under the effect of a differential pressure and using a single connection, which simplifies its assembly and operation.

For instance, the piston may move from the retracted position to the extended position under a pressure exerted by a flow of an inert gas in the cylinder. The inert gas may be chosen from the following: nitrogen, argon, neon, helium, xenon, or combinations thereof.

Additionally, the piston may move from the extended position to the retracted position under a suction pressure obtained by reducing the pressure within the cylinder below the operating pressure of the reactor. Typically, reducing the pressure to or below 300 mbar may allow to achieve the desired effect, even though the exact value will depend on the actual pressure inside the reactor.

It is advantageous for the actuator to have minimal weight, to reduce the friction exerted on the piston. It is further advantageous for the cylinder to have a large diameter compatibly with the space available, to minimize the pressure difference between the inside of the cylinder and the reactor. In this way, a relatively low suction pressure, or gas flow, can actuate the piston.

Under another embodiment, the reactor according to the present invention comprises a linear actuator adapted to move at least one of the thermally insulating components along the longitudinal axis.

In this case, the thermally insulating components may advantageously comprise an upper component situated substantially above the base of the reaction chamber and two lower components situated substantially below the base of the reaction chamber. The linear actuator is coupled with one of the two lower components to displace it along the longitudinal axis. The movable lower component can be displaced from an insulating position where the two lower components are adjacent along the longitudinal axis, to a cooling position where a gap between them is formed, and vice versa. The gap in the insulation system allows to speed up the cooling of the reactor.

The above design reduces the risk of debris contaminating the reaction chamber, especially in the absence of a cover jacket, since the displacement of the insulating components concerns the bottom half of the reactor.

However, it is possible to modify the above embodiment so that the gap is created in the upper half of the reactor, by having one lower component and two upper components, with one of the upper components being displaced by the linear actuator as hereinbefore described.

According to a further embodiment, the thermally insulating components of the reactor according to the invention comprise an outer component and an inner component substantially concentric to each other. They exhibit a different radius but may have same or different lengths in the longitudinal direction. The linear actuator is adapted to linearly displace the outer component from an insulating position which maximizes the coverage with the inner component, to a cooling position which minimizes it. With the term "coverage" in this context it is meant the overlap or projection of the inner and outer component with respect to each other along the longitudinal direction.

In the present embodiment the effect of debris resulting from the displacement of the outer component is counteracted thanks to the protective effects of the inner component, and regardless of whether the displacement occurs in the upper or lower part of the reactor.

Additionally, both the outer and the inner component may comprise at least one through-hole on their major surface. The outer and inner components can be advantageously arranged in such a way that, in the cooling position, the linear actuator displaces the outer component so that their through-holes substantially align, thereby forming a through-hole in the thermal insulation system.

On the other hand, in the insulating position the through-holes are not aligned, thereby limiting heat dispersion.

Under a further embodiment, at least one actuator of the reactor according to the invention is a rotary actuator adapted to rotate at least one thermally insulating component around the longitudinal axis.

In a non-limiting example, the rotary actuator may be a pneumatic actuator suitable to rotate in a first direction under a pressure exerted by flowing an inert gas from an inlet. The actuator may also rotate in a second direction opposite to the first one under a suction pressure exerted through the same inlet, thereby minimizing the number of connections. The suction pressure may be created by lowering the pressure inside the actuator with respect to the pressure of the reaction chamber. A pressure equal to or below 300 mbar would typically suffice.

Alternatively, the rotary actuator may comprise a cylinder and a piston, with the piston being kinematically coupled to one or more mechanical elements suitable to convert linear motion into rotary motion. For example, the piston may be connected to a cam, a slotted link, or a crankshaft mechanism.

In case of a rotary actuator, the thermally insulating components may advantageously comprise an outer component and an inner component substantially concentric to each other so that the outer component may overlap, in toto or in part, with the inner component.

In the present embodiment, the rotary actuator can be adapted to rotate the inner component or the outer component around the longitudinal axis from a cooling position (where the outer component and the inner component partially or completely overlap) to an insulating position (where their overlap is minimized or null).

The above embodiment allows, in the cooling position, to open up large areas of the thermal insulation system to foster cooling of the reactor. Indeed, the displacement of the thermally insulating components (upper and/or lower) is not constrained by the limited displacement available within the reactor in the longitudinal direction. This allows to reduce up to 50% the insulated surface during cooldown operations, thereby taking full advantage of the circular cross section of the reactor to noticeably speed up the process.

The above effect may be achieved, for example, if the rotary actuator is adapted to displace both the inner and the outer component substantially below the base of the reaction chamber when in the cooling position. As a result, the upper part of the reaction chamber is completely exposed, thereby expediting the cooling time of the reactor.

Under another embodiment, the reactor according to the invention further comprises a reactor enclosure surrounding the thermal insulation system. The enclosure may advantageously be a double wall enclosure featuring an interspace suitable to flow a cooling fluid such as water. For instance, the enclosure may comprise two concentric quartz tubes, connected or connectable at their ends.

Advantageously, in the reactor according to the invention, at least one partition element is made of a material having high susceptivity, such as graphite.

Under a second aspect, the present invention relates to a method for controlling the thermal insulation of the reactor according to any of the embodiments hereinbefore described, and comprising the following steps:
- mechanically engaging at least one actuator with at least one thermally insulating component to displace it to an insulating position when the reactor is in operation;
- mechanically engaging at least one actuator with at least one thermally insulating component to displace it to a cooling position when the reactor is cooled down after operation.

This provides the reactor with a thermal insulation system whose efficiency can be tuned based on the insulating requirements before, during, and after deposition. This tunability allows to reduce the cooling downtime of the reactor of more than 50%, thereby improving the overall efficiency and throughput of the same. Additionally, the specific geometry of the reactor, and the embodiments hereinbefore described, limit the impact of any debris formed as a result of moving parts.

Under a third aspect, the present invention relates to a use of the reactor hereinbefore described, for a hot-wall, crossflow, homoepitaxial or heteroepitaxial deposition of silicon, silicon carbide, or gallium arsenide films on a semiconductor substrate.

### DESCRIPTION OF FIGURES

The illustrations presented herein are not meant to be actual views of any particular material, structure, or device, but are merely idealized representations that are used to describe embodiments of the disclosure. Specifically, they are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

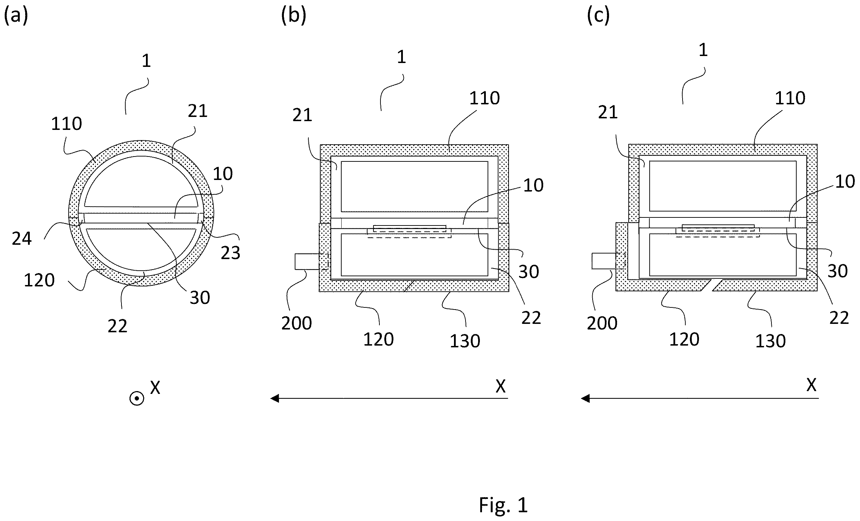

It is noted that in Figures 1-3, the longitudinal axis X has been depicted below the reactor to illustrate its direction with respect to the elements and parts shown, and to improve clarity of the figures. However, the longitudinal axis X should be construed as positioned along the center of the reaction chamber, in particular when it is discussed in connection with the rotation of the thermally insulating elements.

Fig. 1 shows three schematic views of a first embodiment of a hot-wall, crossflow reactor (1) for SiC deposition having a cylindrical geometry and extending along a longitudinal axis.

Fig. 1 (a) shows a cross section of the reactor in a plane perpendicular to the longitudinal axis (X). The reactor features a reaction chamber (10), having a base (30). The chamber, where the epitaxial deposition takes place, is defined by an assembly of four partition elements (21, 22, 23, 24) contained within a thermal insulation system. The latter comprises three thermally insulating components (110, 120, and 130 not visible). The half-moon partition elements (21, 22) may be advantageously made of materials with high susceptivity, such as graphite, to ensure they can reach temperatures up to 1800 °C when subjected to a suitable electromagnetic field. The field may be generated via an induction coil (not shown) wrapped around the reactor. The partition elements (23,24) may be advantageously made of SiC to ensure the currents generated in the partition elements (21,22) circulate along the entire half-moon profile. The reactor (1) typically is protected by an enclosure (not shown), such as a double wall quartz tube, placed between the insulating components and an induction coil used to heat up the reactor.

Fig. 1 (b) shows a cross section of the reactor along the longitudinal axis (X) with the thermally insulating components (110, 120, 130) situated in an insulating position. In this position, all partition elements (21, 22; 23 and 24 not shown), surrounding the reaction chamber (10) with the base (30), are entirely enclosed by the thermal insulation system. This maximizes the insulation of the reactor. The reactor comprises a linear actuator (200) coupled to a movable thermally insulating component (120).

Fig. 1 (c) shows the same lateral cross section of Fig. 1 (b), with the thermally insulating components (110, 120, 130) displaced in a cooling position. In this position, a gap in the thermal insulation system is formed by the displacement of the thermally insulating components (120) under the pull of the actuator (200). This exposes an area of the lower partition element (22) that relatively minimizes the insulation of the reactor and speeds up the reactor's cooling process.

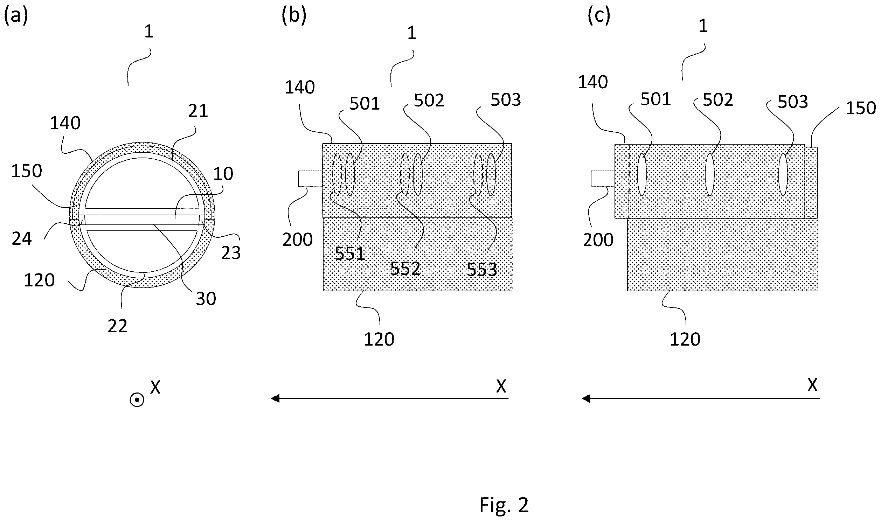

Fig. 2 shows three views of a second embodiment of a reactor (1) according to the invention, having a cylindrical geometry extending along a longitudinal axis (X).

Fig. 2 (a) shows a cross section of the reactor in a plane perpendicular to the longitudinal axis (X). The reactor features three thermally insulating components (120, 140, 150), and specifically an outer component (140) and an inner component (150) placed on the upper part of the reactor, i.e. substantially above the base (30) of the reaction chamber (10) and concentric to each other.

Fig. 2 (b) shows a lateral view of the exterior of the reactor (1) along the longitudinal axis (X), having the thermally insulating components (120, 140, 150) situated in an insulating position. The reactor comprises a linear actuator (200) mechanically coupled to the movable outer component (140), which features three through holes (501, 502, 503). The inner component (150) is also provided with three through holes (551, 552, 553), positioned under the outer component and not visible (identified by a dashed line).

In the insulating position of Fig. 2 (b), the through holes (501, 502, 503) of the outer component (140) and the through holes (551, 552, 553) of the inner component (150) are not aligned. Therefore, the entire outer surface of the partition element (21) is provided with thermal insulation.

It is noted that in the present embodiment the through holes (551, 552, 553) of the inner component have substantially the same shape and spacing as the through holes (501, 502, 503) of the outer component. This is generally advantageous regardless of the shape and number of through holes, as will become apparent in the following.

Fig. 2 (c) shows the same lateral cross section of Fig. 2 (b), with the thermally insulating components (110, 140, 150) displaced in a cooling position. In this position, a gap in the thermal insulation system is formed under the pull of the actuator (200) by aligning the through holes (501, 502, 503) of the outer component (140) with the through holes (551, 552, 553) of the inner component (150), thereby exposing three areas of the upper partition element (21). These exposed areas allow to speed up the reactor's cooling process, by relatively minimizing its insulation.

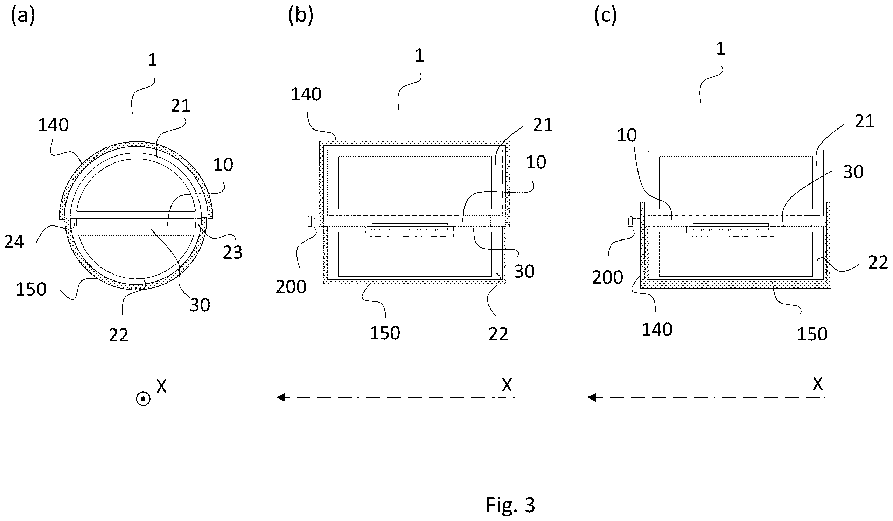

Fig. 3 shows three views of a further embodiment of a reactor (1) according to the invention, having a cylindrical geometry extending along a longitudinal axis (X).

Fig. 3 (a) shows a cross section of the reactor in a plane perpendicular to the longitudinal axis (X). The reactor features two thermally insulating components (140, 150), and specifically an outer component (140) and an inner component (150) respectively placed on the upper and lower part of the reactor, i.e., substantially above and below the base (30) of the reaction chamber.

Fig. 3 (b) shows a lateral cross section of the reactor in a vertical plane along the longitudinal axis (X). In this view, the thermally insulating components (140, 150) are situated in an insulating position, with the outer component (140) and the inner component (150) respectively placed on the upper and lower part of the reactor. In this position, the entire outer surface of the partition elements (21, 22) is enclosed by thermally insulating components. Therefore, the thermal insulation is maximized, as no exposed areas are present. The reactor further comprises a rotary actuator (200) mechanically coupled to the movable outer component (140).

Fig. 3 (c) shows the same lateral cross section of Fig. 3 (b), with the thermally insulating components (140, 150) displaced in a cooling position. In this position, the actuator (200) has caused the outer component (140) to rotate around the longitudinal axis, thereby exposing the outer surface of the upper partition element (21). This exposed area allows to speed up the reactor's cooling process.

The subject matter of the present disclosure includes all novel and nonobvious combinations and sub-combinations of the various processes, systems, and configurations, and other features, functions, acts, and/or properties disclosed herein, as well as any and all equivalents thereof.

In the description and the claims in this application the words "comprise" and its variations such as "comprising" and "comprises" do not rule out the presence of other additional elements, components, or stages.

The discussion of documents, deeds, materials, apparatus, articles and the like is included in the text solely for the purpose of providing context for this invention; it should not however be understood that this material or part thereof constitutes general knowledge in the field relating to the invention prior to the priority date of each of the claims appended to this application.

## Claims

1. A Reactor (1) suitable for the epitaxial deposition of a semiconductor film on a substrate, comprising: (i) a reaction chamber (10) formed by at least one partition element (21, 22, 23, 24) and having a base (30) adapted to receive a substrate holder; (ii) a thermal insulation system adapted to provide thermal insulation for the reaction chamber; **characterized in that**:
- the reactor extends along a longitudinal axis (X) and features a substantially circular cross section in a plane perpendicular to said longitudinal axis; and
- the thermal insulation system comprises a plurality of thermally insulating components (110, 120, 130, 140, 150) having a circular or arc shaped cross section in a plane perpendicular to said longitudinal axis, and at least one actuator (200);
wherein the at least one actuator is adapted to displace at least one of the thermally insulating components from an insulating position to a cooling position and vice versa; the insulating position and the cooling position being respectively adapted to relatively maximize and minimize the thermal insulation of the reaction chamber.

2. The reactor according to claim 1, further comprising at least one cover jacket positioned between the at least one partition element and the thermal insulation system.

3. The reactor according to claim 2, wherein said cover jacket is made of graphite or a thermally insulating material.

4. The reactor according to any one of claims 1-3, wherein the at least one actuator is substantially made of, or coated with, a heat resistant material, preferably ceramic, quartz, borosilicate glass, sapphire glass, graphite or combinations thereof.

5. The reactor according to any one of claims 1-4, wherein the at least one actuator is adapted to move at least one thermally insulating component along the longitudinal axis and comprises:
- a cylinder (210); and
- a piston (220) adapted to move within said cylinder from a retracted position to an extended position and vice versa;
said piston being connected or connectable to at least one of the thermally insulating components.

6. The reactor according to claim 5, wherein:
- the piston moves from the retracted position to the extended position under a pressure exerted by a flow of an inert gas into the cylinder; and
- the piston moves from the extended position to the retracted position under a suction pressure obtained by reducing the pressure within the cylinder below the operating pressure of the reactor.

7. The reactor according to any one of the preceding claims, wherein the actuator is a linear actuator.

8. The reactor according to claim 7, wherein the plurality of thermally insulating components comprises an upper component (110) situated substantially above the base of the reaction chamber and two lower components (120, 130) situated substantially below the base of the reaction chamber; the linear actuator being adapted to linearly displace along the longitudinal axis one of the two lower components from an insulating position where the two lower components are adjacent along the longitudinal axis, to a cooling position where a gap between said two lower components is formed along the longitudinal axis, and vice versa.

9. The reactor according to claim 7, wherein the plurality of thermally insulating components comprises: an outer component (140) and an inner component (150) substantially concentric to each other; and:
- the outer component is adapted to provide, in toto or in part, external coverage to the inner component; and
- the linear actuator is adapted to linearly displace the outer component from an insulating position, relatively maximizing the coverage of the inner component, to a cooling position, where said coverage is relatively minimized, and vice versa.

10. The reactor according to claim 9, wherein:
- the outer component comprises at least one through-hole (501, 502, 503) on its major surface; and
- the inner component comprises at least one through-hole (551, 552, 553) on its major surface;
the inner and outer components being arranged so that: (i) in the cooling position the at least one through-hole of the outer component and the at least one through-hole of the inner component substantially align to form at least one through-hole in the thermal insulation system; and (ii) in the insulating position the at least one through-hole of the outer component and the at least one through-hole of the inner component are not aligned.

11. The reactor according to any one of claims 1-4, wherein the at least one actuator is a rotary actuator adapted to rotate at least one thermally insulating component around the longitudinal axis.

12. The reactor according to claim 11 wherein the rotary actuator is a pneumatically controlled and is suitable to rotate in a first direction under a pressure exerted by a gas flow, and to rotate in a second direction opposite to the first one under a suction pressure.

13. The reactor according to claim 5 or 6, wherein the at least one actuator is a rotary actuator, and the piston is kinematically coupled to one or more mechanical elements suitable to convert a linear motion into a rotary motion.

14. The reactor according to any one of claims 11-13, wherein the plurality of thermally insulating components comprises at least one outer component (140) and at least one inner component (150) substantially concentric to each other, where:
- the outer component is adapted to provide external coverage, in toto or in part, to the inner component; and
- the rotary actuator is adapted to rotate the inner component and/or the outer component around the longitudinal axis from a cooling position to an insulating position.

15. The reactor according to any of the preceding claims, further comprising a reactor enclosure surrounding the insulation system.

16. The reactor according to claim 15, wherein the reactor enclosure is a double wall enclosure featuring an interspace suitable to flow a cooling fluid.

17. The reactor according to any of the preceding claims, where at least one partition element (21, 22) is a susceptor.

18. A method for controlling the thermal insulation of the reactor (1) according to any one of claims 1 to 17, comprising the following steps:
- mechanically engaging at least one actuator (200) with at least one thermally insulating component (110, 120, 130, 140, 150) to displace it to an insulating position when the reactor is in operation;
- mechanically engaging at least one actuator with at least one thermally insulating component to displace it to a cooling position when the reactor is cooled down after operation.

19. A use of the reactor (1) according to any one of claims 1 to 17 for a hot-wall, crossflow deposition of silicon, silicon carbide, or gallium arsenide films on a semiconductor substrate.
